Europäisches Patentamt

(19) European Patent Office

Office européen des brevets

(11) Publication number: **0 143 531**
A1

## EUROPEAN PATENT APPLICATION

(21) Application number: **84306618.4**

(22) Date of filing: **28.09.84**

(51) Int. Cl.⁴: **H 01 B 1/22,** H 05 K 3/12, C 09 D 5/24, B 05 D 5/12

(30) Priority: **30.09.83 US 537649**

(43) Date of publication of application: **05.06.85** Bulletin 85/23

(84) Designated Contracting States: **AT BE CH DE FR GB IT LI LU NL SE**

(71) Applicant: **ELECTRO MATERIALS CORP. OF AMERICA, 605 Center Avenue, Mamaroneck New York 10543 (US)**

(72) Inventor: **Martin, Frank Wayne, P.O.Box 243, Baldwin Place New York 10505 (US)** Inventor: **St. John, Frank, 1 Webster Place, Patterson New York 12563 (US)**

(74) Representative: **Angell, David Whilton, Rohm and Haas Company Patent Department Chesterfield House Bloomsbury Way, London WC1A 2TP (GB)**

(54) A method of forming a solderable, electrically conductive film on a substrate and the conductive composition itself.

(57) A solderable electrically conductive film is formed on a substrate by forming a film-forming composition comprising polyimide, solvent therefor and dispersed metallic nickel particles. This composition is applied to the substrate, dried and cured to leave the film which comprises nickel particles dispersed in polyimide.

EP 0 143 531 A1

A METHOD OF FORMING A SOLDERABLE, ELECTRICALLY CONDUCTIVE
FILM ON A SUBSTRATE AND THE CONDUCTIVE COMPOSITION ITSELF

The invention is concerned with a method of forming a solderable, electrically conductive film on a substrate and the conductive composition itself. The invention provides a solderable electrically conductive nickel polymer thick film.

Conductive polymer films are well known, and used in connection with printed circuits to connect the elements of the circuit and to provide an electrical connection to another circuit. Most of these conductive polymer films contain noble metals, such as silver or gold, to render them conductive and are therefore expensive to manufacture.

Typically, the films are applied to a substrate, such as a circuit board, by silk screening methods and then cured. Present conductive polymer films will not accept solder and require the application of a plated metal surface which is solderable. The plated metal surface may be applied by either electroless or electroplate techniques. Electrical connections may then be made to the conductive film by soldering the electrical leads to the plated metal surface. Soldering must be performed very carefully as the conductive polymer films containing silver are subject to leaching. Specifically, during the application of solder the silver particles tend to be dissolved into the solder and run off the substrate. This renders the polymer film deficient in conductive particles, resulting in a loss of electrical conductivity and leaving the substrate unusable.

The plating of presently available conductive polymer films is required to render them solderable. The plating currently applied to most conductive polymer films is an electroless bath of either nickel boron or nickel phosphorus. Plating, however, is inconvenient on a small scale and presents major problems where substantial production of plated conductive polymer films (such as in printed circuit boards) is contemplated. For example, electroless nickel plating of conductive polymer films on a volume production basis requires the establishment of a suitable plating facility which is a large, expensive and complicated venture. Specifically, the plating room must have a suitable quantity and quality of ventilation and the various levels of air flow must be controlled. The tanks used for plating should be formed from fiberglass, polypropylene, polyethylene or other suitable high temperature resistant (200°F range) material. The tanks must also be capable of withstanding nitric acid cleaning on a periodic basis. In addition, a holding tank and a transfer system is required to empty and refill the plating tank when nickel salts reach a certain concentration requiring that the tank be purged. Low watt density immersion heaters made of quartz or passivated stainless steel are necessary to provide the appropriate level of heat. The use of immersion heaters require agitation by forced air impinging directly on the heaters to avoid localized heating. Jacketed tanks may be used in place of the immersion heaters but vigorous agitation is required in any case. The use of non-metallic or other acid resistant products is recommended. Continuous filtration of the plating bath must be performed each day. A polypropylene cartridge filter is recommended, which filter should be purged with hot water and the cartridge filter changed 6 to 10 times per hour for continuous filtration. Of course, the continuous filtration requires a pump suitable for continuous operation at 200°F.

It will readily be appreciated that a solderable conductive film would eliminate the need for the entire plating operation described above and is therefore highly desirable. In addition, a solderable conductive film formed from a non-noble metal would be made from less expensive materials. Also, a non-noble metal, such as nickel, is less likely to leach, (dissolve into the solder) and run off the substrate during soldering.

Accordingly, one object of the present invention is to provide an electrically conductive polymer film which is solderable.

Another object of the present invention is to provide an electrically conductive polymer film which is solderable without the application of a plated metal surface or any other subsequent coating operation.

Still another object of the present invention is to provide an electrically conductive polymer film which is solderable by any standard soldering technique.

A further object of the present invention is to provide a solderable electrically conductive polymer film which may be applied to any substrate capable of withstanding the curing temperature of the film.

A still further object of the present invention is to provide a solderable electrically conductive polymer film which uses less expensive materials in manufacture than conductive polymer films of the prior art.

An additional object of the present invention is to provide a solderable electrically conductive polymer film in which the conductive particles will not leach off the substrate during soldering.

In accordance with the present invention a solderable electrically conductive composition includes metallic nickel particles embedded in a matrix of polyimide. The composition can be formed by dissolving polyimide in a solvent to form a solution, dispersing metallic nickel particles within the solution and applying the resulting film-forming composition to a substrate on which it is dried and cured, by the application of heat, to evaporate the solvent and allow polymerization to occur, leaving a solderable electrically conductive film on the substrate.

The solderable electrically conductive composition of the present invention is made up of metallic nickel particles dispersed within polyimide. The composition can be formed by dissolving a suitable polyimide, such as the polyimide sold under the trademark XU218 by Ciba Geigy or the polyimide sold by Dupont or Rohm and Haas, in a solvent to form a solution. Typical solvents include acetone, gamma butyrolactone, acetophenone and cyclohexanone. Once the polyimide is dissolved within the solvent the metallic nickel particles are added to the solution. The nickel particles may be in either a granular powder or a flake form, with a typical particle size of 1 to 10 microns. Each of the materials, nickel, polyimide, and solvent are weighed in clean stainless steel bowls. The polyimide is dissolved in the solvent to form a solution to which the nickel powder is added. The solution with the nickel is then blended with a mixer until the nickel powder is dispersed, thereby forming an ink or paste. The nickel should preferably make up from 50 to 85% by weight of the ink with a more preferred range being 60 to 75%. The polyimide should preferably make up from 1 to 20% by weight of the ink with a more preferred range being 3 to 10%. The solvent should preferably make up from 10 to 40% by weight of the ink with a more preferred range being 15 to 30%. A ratio of one part polyimide to five parts solvent is desirable.

The ink is then milled using a 3-roll mill until a desired fineness of grind is achieved. This may require three to six passes through the 3-roll mill.

The viscosity of the ink may be lowered with the addition of more solvent in 0.5% by weight increments. A viscosity of 50,000 to 150,000 centipoise (cps) is desired for most applications. The ink may then be applied to any substrate capable of withstanding the curing temperature of the ink. For example, the ink may be screen printed onto conventional circuit boards to connect one element of a circuit to another or to provide an electrical connection to another circuit. For this application the ink may be screen printed using conventional silk screening methods. The ink may also be applied to the leads of surface mounted devices such as capacitors, light emitting diodes, solar cells, dual in-line package integrated circuits and small outline integrated circuit packages. For this application the leads of the surface mounted devices may be dipped in the ink or the ink may be sprayed onto the leads. The ink may also be used to provide the leads for leadless surface mounted devices.

The ink forms a film on the substrate which then must be dried and cured. The film is first dried preferably by exposing the substrate to an ambient temperature from 40 to 120° centigrade (C) for approximately 10 to 30 minutes. It is more preferred, however, that the ambient temperature be from 70 to 80°C and that the drying time be from 18 to 22 minutes. After the ink has been dried it is cured preferably by exposing the substrate to an ambient temperature between 80 to 245°C for 5 to 15 minutes. It is more preferred that the curing temperature be from 150 to 180°C and that the curing time be from 9 to 11 minutes.

During drying and curing the solvent is evaporated and polymerization occurs leaving a hard, solderable, electrically conductive film formed from metallic nickel particles embedded in a matrix of polyimide. It will readily be appreciated that the metal content of the film is greater after curing, as the solvent has evaporated.

The cured film can provide good electrical conductivity having a resistivity of 1 to 10 ohms per square per 0.025 mm (1 mil) thick. Any size square of the cured film having a thickness of 0.025 mm (1 mil) will have a resistivity of 1 to 20 ohms. In addition, the film exhibits solderability in that solder adheres directly to the film and as a result no plating is necessary. Solder may be applied by use of a soldering iron or any standard soldering technique. No special flux is required and standard activated rosin flux may be used. In addition, the cured film may be soldered by a solder dip process without the problem of solder leach (the dissolving of the conductive nickel particles into the solder) as the nickel does not leach off the substrate as do other conductors.

A preferred embodiment, which is here given for the purposes of illustration only, of the solderable electrically conductive composition made in accordance with the present invention is formed from nickel flake, making up about 75% by weight of the ink, gamma butyrolactone, making up about 20% by weight of the ink, and polyimide making up about 5% by weight of the ink. The ink may be thinned with gamma butyrolactone to provide a viscosity between 100 and 150 N s/m$^2$ (100,000 and 150,000 cps). The ink is then screen printed on a substrate forming lines of conductive film 0.254 mm (10 mils) in width and with a spacing of 0.254 mm (10 mils) from other lines. The film is dried at 75°C for 20 minutes and then cured at 165°C for 10 minutes. During drying and curing the solvent evaporates leaving a hard, solderable, electrically conductive film. The metallic nickel particles make up approximately 94% by weight of the cured film and the polyimide makes up approximately 6% by weight of the cured film.

The cured film is both conductive and solderable. The resistivity of the film is between 1 to 10 ohms per square per 0.025 mm (1 mil) thick. The cured film accepts solder, specifically a 60/40% tin/lead solder. After using flux, the solder may be applied at 220°C with the substrate containing the cured film preheated for 5 seconds. The film adheres well to the substrate, requiring 13.34 to 22.24 N (3 to 5 pounds force) to remove it therefrom.

CLAIMS:

1.    A method for forming a solderable electrically conductive film on a substrate which comprises forming a film-forming composition comprising solvent, polyimide dissolved therein and dispersed metallic nickel particles, applying said composition to a substrate to form a film thereon and drying and curing said film by heating so that the solvent evaporates to leave a solderable electrically conductive film on said substrate.

2.    A method as claimed in Claim 1 in which said substrate is a circuit board or a lead of an electrical device or leadless electrical device in which said film forms an electrical lead.

3.    A method as claimed in Claim 2 in which said solution is applied to said circuit board by screen printing.

4.    A method as claimed in Claim 1 in which said solvent comprises acetone, gamma butyrolactone, acetophenone and/or cyclohexanone.

5.    A method as claimed in any preceding claim wherein the film-forming composition comprises 1 to 20% by weight polyimide, 50 to 85% by weight nickel particles and 10 to 40% by weight solvent.

6.    A method as claimed in any of Claims 1 to 4 in which the film-forming composition contains 3 to 10% by weight polyimide.

7.    A method as claimed in any of Claims 1 to 4 and 6 in which the film-forming composition contains 60 to 75% by weight metallic nickel particles.

8. A method as claimed in any of Claims 1 to 4, 6 and 7 in which the film-forming composition contains 15 to 30% by weight solvent.

9. A method as claimed in any preceding claim wherein drying is effected by the application of a temperature of 40 to 120°C for 10 to 30 minutes, preferably 70 to 80°C for 18 to 22 minutes.

10. A method as claimed in any preceding claim wherein curing is effected by the application of a temperature of 80 to 245°C for 5 to 15 minutes preferably 150 to 180°C for 9 to 11 minutes.

11. A solderable electrically conductive composition comprising metallic nickel particles dispersed within polyimide.

0143531

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| Y | US-A-4 233 103 (J.M.SHAHEEN) *Column 1, lines 44-56* | 1 | H 01 B 1/22<br>H 05 K 3/12<br>C 09 D 5/24<br>B 05 D 5/12 |
| | --- | | |
| Y | EP-A-0 082 477 (DU PONT DE NEMOURS) *Page 4, lines 18-24* | 1 | |
| | ----- | | |

TECHNICAL FIELDS SEARCHED (Int. Cl.4)

B 05 D
C 09 D
H 01 B
H 05 K

The present search report has been drawn up for all claims

| Place of search THE HAGUE | Date of completion of the search 16-01-1985 | Examiner VAN THIELEN J.B. |
|---|---|---|